# EUROPEAN PATENT APPLICATION

(11) **EP 4 582 826 A1**
(43) Date of publication of application: **09.07.2025**
(21) Application number: 22957329.0
(22) Date of filing: 30.08.2022
(51) Int. Cl.: G01R 33/02

(54) **MAGNETIC SENSOR**

(71) Applicant: TDK Corporation, Tokyo 103-6128 (JP)
(72) Inventor: YAMAJI Yuichiro, Tokyo 103-6128 (JP); HARAKAWA Osamu, Binan, Laguna (PH)
(74) Representative: Epping - Hermann - Fischer
(86) International application number: PCT/JP2022/032505
(87) International publication number: WO 2024/047726

(57) **Abstract**

To reduce the influence that a magnetic field generated from the end portion of a compensation coil has on a magnetosensitive element. A magnetic sensor 1 includes an external magnetic body 30 for collecting a magnetic field to be detected in a sensor chip 20, a compensation coil 60 wound around the external magnetic body 30 through a bobbin part 51 of a molded member 50, and a connecting terminal 71 fixed to a terminal fixing part 52 of the molded member 50 and connected with one end of the compensation coil 60. The terminal fixing part 52 has a bobbin connecting surface S1 and a terminal fixing surface S2. The compensation coil 60 has, at its one end, a section 61 extending along the bobbin connecting surface S1 and a section 62 extending along the terminal fixing surface S2. With this configuration, it is possible to reduce the influence that a magnetic field generated from the end portion of the compensation coil has on a magnetosensitive element.

## Description

### [Technical Field]

The present invention relates to a magnetic sensor and, more particularly, to a magnetic sensor having an external magnetic body for collecting magnetic flux in a magnetosensitive element and a compensation coil.

### [Background Art]

As the magnetic sensor having an external magnetic body for collecting magnetic flux in a magnetosensitive element and a compensation coil, a magnetic sensor described in JP 2022-046892A is known. The magnetic sensor described in JP 2022-046892A has a molded member fixed to an external magnetic body, and end portions of a compensation coil are connected to connecting pins held by the molded member. This facilitates connection between the compensation coil and a feedback circuit.

### [Citation List]

### [Patent Document]

[Patent Document 1] JP 2022-046892A

### [Disclosure of the Invention]

### [Problem to be Solved by the Invention]

A large part of the compensation coil is wound around the external magnetic body, so that a magnetic field generated by a current flowing in the compensation coil is almost directed in the axial direction of the external magnetic body. However, a slight magnetic field is generated also from the end portion of the compensation coil connected to the connecting pin, and there is thus required a magnetic sensor having a structure that prevents such a magnetic field from becoming noise.

An object of the present invention is therefore to, in a magnetic sensor having an external magnetic body for collecting magnetic flux in a magnetosensitive element and a compensation coil, reduce the influence that a magnetic field generated from the end portion of the compensation coil has on the magnetosensitive element.

### [Means for Solving the Problem]

A magnetic sensor according to the present invention includes: a sensor chip having a magnetosensitive element; an external magnetic body for collecting a magnetic field to be detected in the magnetosensitive element; a molded member having a bobbin part that cover the external magnetic body and a terminal fixing part; a compensation coil wound around the external magnetic body through the bobbin part of the molded member; and a first connecting terminal fixed to the terminal fixing part of the molded member and connected with one end of the compensation coil. The axis direction of the bobbin part of the molded member is a first direction, and the terminal fixing part of the molded member has a bobbin connecting surface extending perpendicular to the first direction and connected with the bobbin part and a terminal fixing surface extending in parallel to the first direction and fixed with the first connecting terminal. The one end of the compensation coil has a first section extending along the bobbin connecting surface and a second section extending along the terminal fixing surface.

According to the present invention, one end of the compensation coil extends along the bobbin connecting surface and terminal fixing surface, thereby preventing the position of the one end of the compensation coil from changing from condition to condition and product to product. This makes it possible to reduce the influence that a magnetic field generated from the end portion of the compensation coil has on the magnetosensitive element.

The magnetic sensor according to the present invention may further include a second connecting terminal fixed to the terminal fixing part of the molded member and connected with the other end of the compensation coil, the second connecting terminal may be fixed to the terminal fixing surface of the terminal fixing part, and the other end of the compensation coil may have a third section extending along the bobbin connecting surface and a fourth section extending along the terminal fixing surface. This prevents the position of the other end of the compensation coil from changing from condition to condition and product to product. In addition, the first and second connecting terminals are fixed to the terminal fixing surface of the terminal fixing part. This allows a magnetic field generated from the second section and a magnetic field generated from the fourth section to cancel each other.

In the present invention, the first and third sections may extend in parallel to each other. This allows a magnetic field generated from the first section and a magnetic field generated from the third section to effectively cancel each other.

In the present invention, the second and fourth sections may extend in parallel to each other. This allows a magnetic field generated from the second section and a magnetic field generated from the fourth section to effectively cancel each other.

In the present invention, both the second and fourth sections may extend in the first direction. This can further reduce the influence that magnetic fields generated from the second and fourth sections have on the magnetosensitive element.

In the present invention, the terminal fixing surface may extend in the first direction and a second direction perpendicular to the first direction, the terminal fixing part may further include a positioning part on the terminal fixing surface, and the second section of the compensation coil may be positioned in the second direction by the positioning part. This makes the second section of the compensation coil unlikely to be displaced in the second direction.

In the present invention, the external magnetic body may include a first area facing the sensor chip in the first direction and a second area positioned on the side opposite to the sensor chip with respect to the first area, the second area may be smaller in height dimension in the second direction perpendicular to the first direction than the first area, and the bobbin part of the molded member may cover the second area of the external magnetic body. Thus, even in a state where the external magnetic body and molded member are mounted on a substrate, interference between the compensation coil and the substrate can be prevented.

### [Advantageous Effects of the Invention]

As described above, according to the present invention, in a magnetic sensor having an external magnetic body for collecting magnetic flux in a magnetosensitive element and a compensation coil, it is possible to reduce the influence that a magnetic field generated from the end portion of the compensation coil has on the magnetosensitive element.

### [Brief Description of the Drawings]

[FIG. 1]

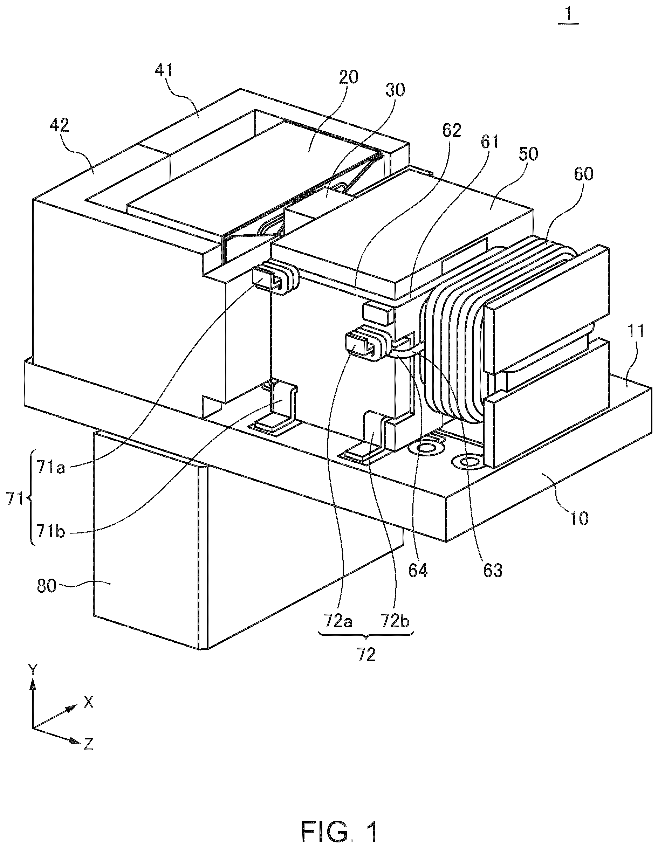

   FIG. 1 is a schematic perspective view illustrating the outer appearance of a magnetic sensor 1 according to an embodiment of the present invention.
[FIG. 2]

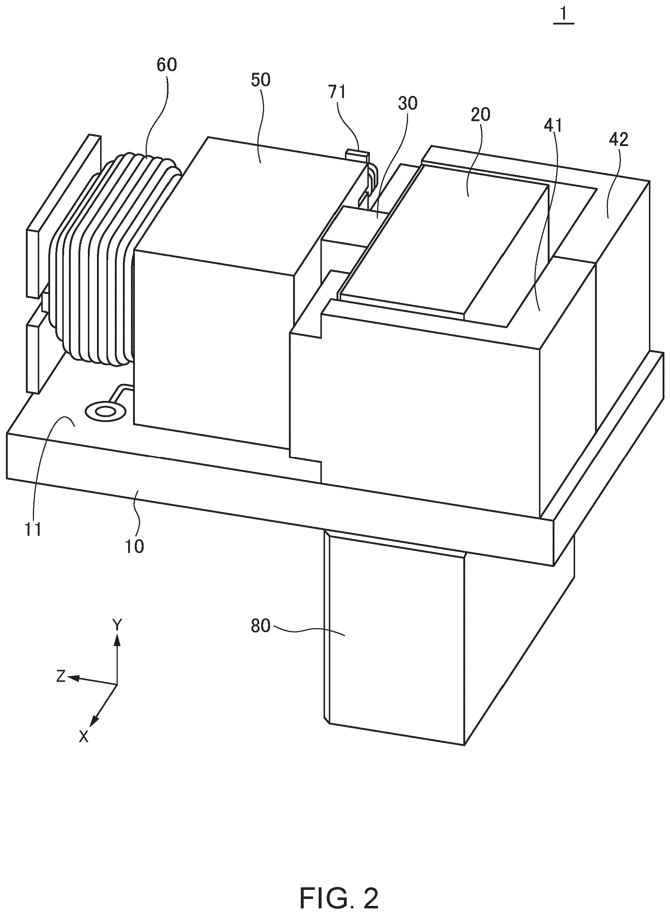

   FIG. 2 is a schematic perspective view illustrating the outer appearance of a magnetic sensor 1 as viewed from different direction from FIG. 1.
[FIG. 3]

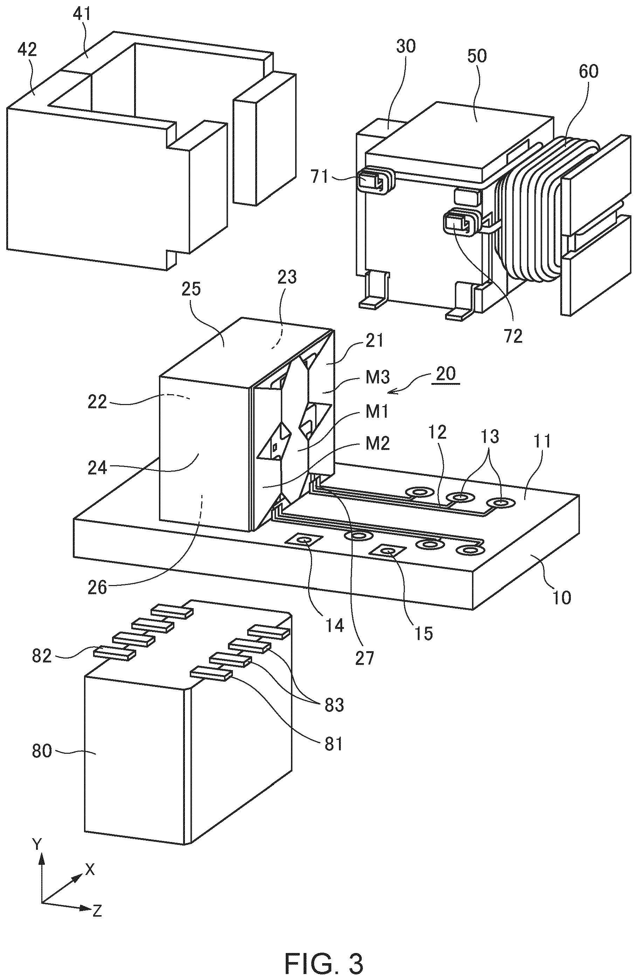

   FIG. 3 is a schematic exploded perspective view of the magnetic sensor 1.
[FIG. 4]

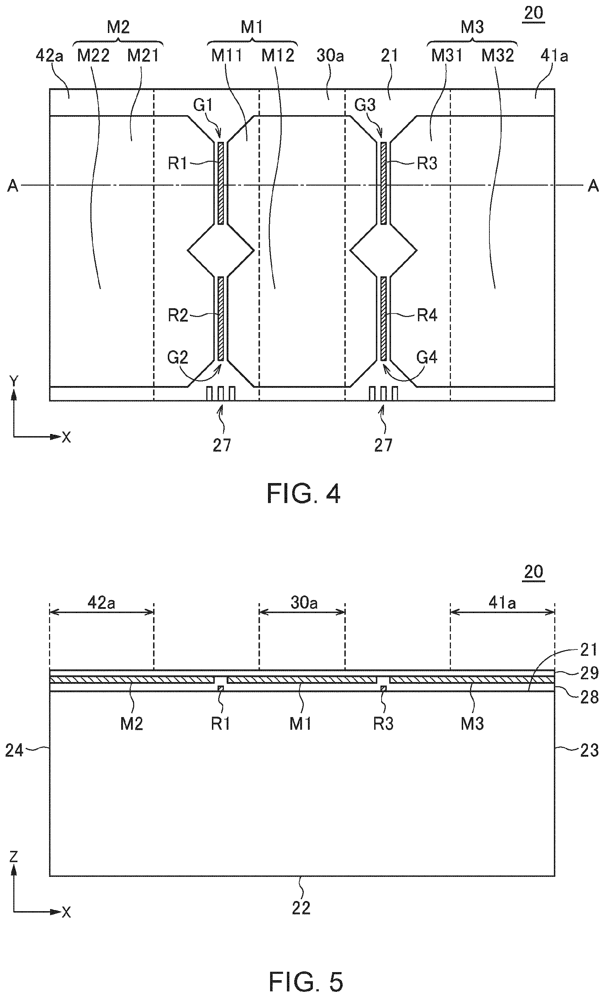

   FIG. 4 is a schematic plan view of the sensor chip 20.
[FIG. 5]
   FIG. 5 is a schematic cross-sectional view taken along the line A-A in FIG. 4.
[FIG. 6]

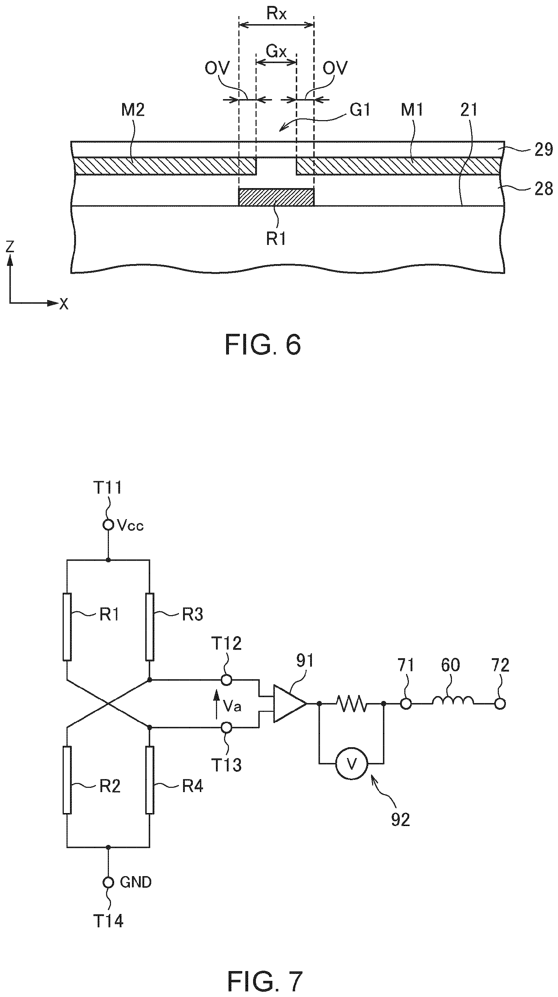

   FIG. 6 is a schematic cross-sectional view for explaining an example in which the magnetic layers and the magnetosensitive element overlap each other.
[FIG. 7]
   FIG. 7 is a circuit diagram for explaining the connection relationship between the magnetosensitive elements R1 to R4 and the compensation coil 60.
[FIG. 8]

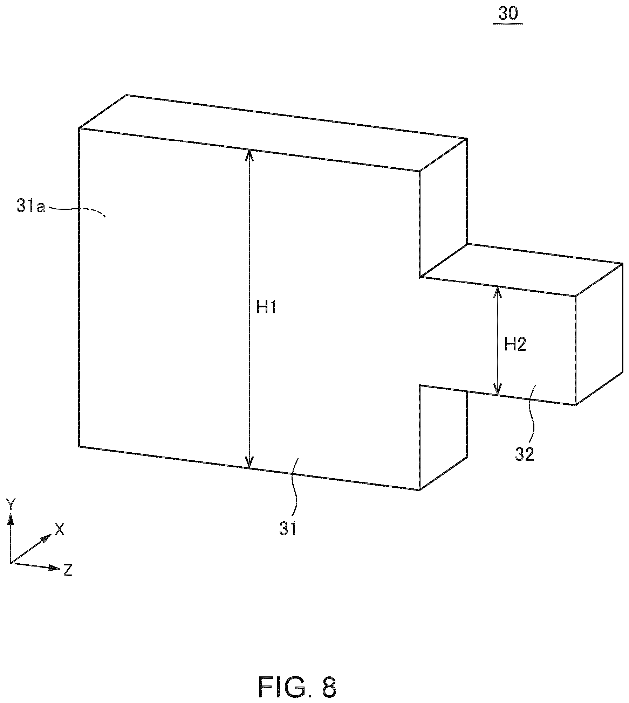

   FIG. 8 is a schematic perspective view for explaining the structure of the external magnetic body 30.
[FIG. 9]

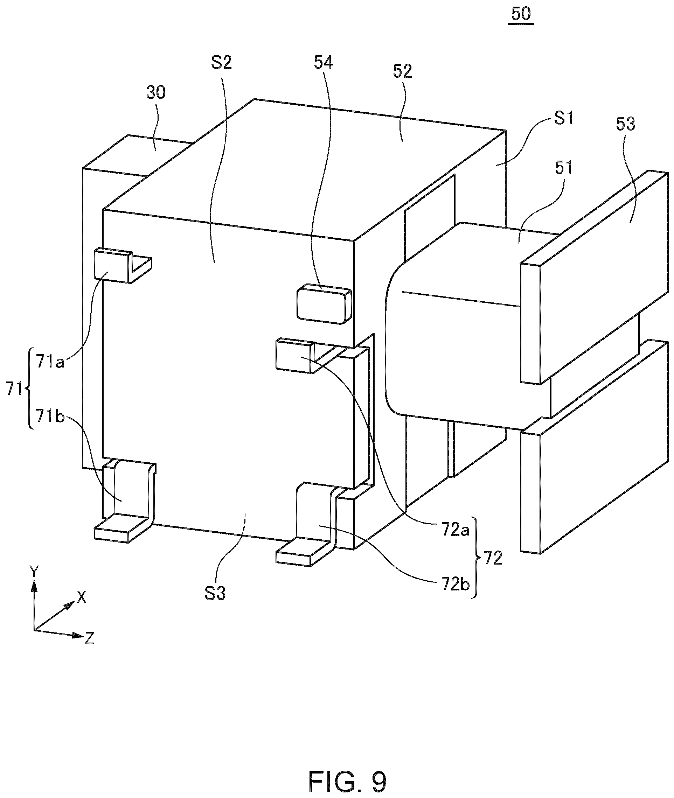

   FIG. 9 is a schematic perspective view for explaining the structure of the molded member 50.

### [Mode for Carrying Out the Invention]

Hereinafter, preferred embodiments of the present invention will be described in detail with reference to the accompanying drawings.

FIGS. 1 and 2 are schematic perspective views illustrating the outer appearance of a magnetic sensor 1 according to an embodiment of the present invention as viewed from mutually different directions. FIG. 3 is a schematic exploded perspective view of the magnetic sensor 1.

As illustrated in FIGS. 1 to 3, the magnetic sensor 1 according to the present embodiment includes a substrate 10, a sensor chip 20, external magnetic bodies 30, 41, and 42, a molded member 50, a compensation coil 60, and a pair of connecting terminals 71 and 72. The sensor chip 20, external magnetic bodies 30, 41, and 42, and molded member 50 are mounted on a surface 11 constituting the XZ plane of the substrate 10. The compensation coil 60 is wound around the molded member 50. The pair of connecting terminals 71 and 72 are fixed to the molded member 50. The sensor chip 20 has an element formation surface 21 and a back surface 22 which constitute the XY plane, side surfaces 23 and 24 which constitute the YZ plane, and side surfaces 25 and 26 which constitute the XZ plane and is mounted on the substrate 10 such that the side surface 26 faces the surface 11 of the substrate 10. A magnetosensitive element and magnetic layers M1 to M3 (to be described later) are formed on the element formation surface 21 of the sensor chip 20. Thus, in the present embodiment, the surface 11 of the substrate 10 and the element formation surface 21 of the sensor chip 20 are perpendicular; however, they need not necessarily be perfectly perpendicular in the present invention, but the angular relationship therebetween may deviate from perpendicularity in a certain amount.

The external magnetic bodies 30, 41, and 42 act to collect magnetic flux in the sensor chip 20 and are all made of a high permeability material such as ferrite. The external magnetic body 30 has a bar-like body elongated in the Z-direction and is positioned at substantially the X-direction center of the element formation surface 21 so as to cover a part of the magnetic layer M1. The external magnetic bodies 41 and 42 are positioned on the side opposite to the external magnetic body 30 with respect to the sensor chip 20. The external magnetic body 41 covers a part of the magnetic layer M2, the side surface 23 of the sensor chip 20, and a part of the back surface 22 of the sensor chip 20. The external magnetic body 42 covers a part of the magnetic layer M3, the side surface 24 of the sensor chip 20, and another part of the back surface 22 of the sensor chip 20. With this configuration, a magnetic field in the Z-direction is selectively collected, and the collected magnetic field is applied to the sensor chip 20.

The molded member 50 is made of a nonmagnetic insulating material such as resin and is fixed to the external magnetic body 30 through an adhesive or the like. The molded member 50 is wound with the compensation coil 60 and has the connecting terminals 71 and 72 fixed thereto. The connecting terminals 71 and 72 each have a main body part and terminal parts. The main part is embedded in the molded member 50 and extends in the Y-direction. The terminal parts are obtained by bending both ends of the main body part in the X-direction. A terminal part 71a of the connecting terminal 71 is connected with one end of the compensation coil 60, and a terminal part 72a of the connecting terminal 72 is connected with the other end of the compensation coil 60. Further, a terminal part 71b of the connecting terminal 71 and a terminal part 72b of the connecting terminal 72 are connected to land patterns provided on the surface 11 of the substrate 10. Details of the structures of the molded member 50 and compensation coil 60 will be described later.

FIG. 4 is a schematic plan view of the sensor chip 20, and FIG. 5 is a schematic cross-sectional view taken along the line A-A in FIG. 4.

As illustrated in FIGS. 4 and 5, four magnetosensitive elements R1 to R4 are formed on the element formation surface 21 of the sensor chip 20. The magnetosensitive elements R1 to R4 are not particularly limited in type as long as they are elements whose electric resistance varies depending on the direction of magnetic flux and may be, for example, an MR element. The fixed magnetization directions of the magnetosensitive elements R1 to R4 are the same direction (for example, positive X-direction). The magnetosensitive elements R1 to R4 are covered with an insulating layer 28, on the surface of which magnetic layers M1 to M3 made of permalloy or the like are formed. The magnetic layers M1 to M3 are covered with an insulating layer 29. Assume that parts of the respective magnetic layers M1 to M3 that are positioned at one side (upper side in FIG. 4) in the Y-direction are defined as magnetic layers M11, M21, and M31, and parts of the respective magnetic layers M1 to M3 that are positioned at the other side (lower side in FIG. 4) in the Y-direction are defined as magnetic layers M12, M22, and M32. In this case, in a plan view (as viewed in the Z-direction), the magnetosensitive element R1 is positioned between the magnetic layers M11 and M21, the magnetosensitive element R2 is positioned between the magnetic layers M12 and M22, the magnetosensitive element R3 is positioned between the magnetic layers M11 and M31, and the magnetosensitive element R4 is positioned between the magnetic layers M12 and M32. With this configuration, magnetic fields passing through respective magnetic gaps G1 to G4 are applied respectively to the magnetosensitive elements R1 to R4.

However, in the present invention, the magnetosensitive elements R1 to R4 each need not be positioned between two corresponding magnetic layers but may be at least disposed respectively in the vicinity of magnetic gaps G1 to G4 each formed between two magnetic layers. That is, the magnetosensitive elements R1 to R4 only need to be disposed on magnetic paths formed by the respective magnetic gaps G1 to G4. Further, the width of each of the magnetic gaps G1 to G4 need not be larger than the width of each of magnetosensitive elements R1 to R4 and may be smaller than the width of each of magnetosensitive elements R1 to R4. In the example illustrated in FIG. 6, a width Gx of the magnetic gap G1 in the X-direction is smaller than a width Rx of the magnetosensitive element R1 in the X-direction, and thus the magnetic layers M1 and M2 have an overlap OV with the magnetosensitive element R1 in the Z-direction. The positional relationship between the magnetic gaps G1 to G4 and the magnetosensitive elements R1 to R4 may be that illustrated in FIG. 6.

In FIGS. 4 and 5, areas designated respectively by reference numerals 30a, 41a, and 42a are areas covered respectively with the external magnetic bodies 30, 41, and 42. As illustrated in FIGS. 4 and 5, the external magnetic body 30 covers the magnetic layer M1, the external magnetic body 41 covers the magnetic layer M2, and the external magnetic body 42 covers the magnetic layer M3.

FIG. 7 is a circuit diagram for explaining the connection relationship between the magnetosensitive elements R1 to R4 and the compensation coil 60.

As illustrated in FIG. 7, the magnetosensitive element R1 is connected between terminal electrodes T11 and T13, the magnetosensitive element R2 is connected between terminal electrodes T12 and T14, the magnetosensitive element R3 is connected between terminal electrodes T11 and T12, and the magnetosensitive element R4 is connected between terminal electrodes T13 and T14. The terminal electrodes T11 to T14 constitute a terminal electrode group 27 illustrated in FIG. 3. The terminal electrode group 27 is provided on the sensor chip 20 and connected to a connector 80 provided on the back surface of the substrate 10 through a wiring 12 formed on the surface 11 of the substrate 10 and via conductors 13 penetrating the substrate 10. The terminal electrode T11 is applied with a power supply potential Vcc, and the terminal electrode T14 is applied with a ground potential GND. Since the magnetosensitive elements R1 to R4 have the same fixed magnetization direction, a difference occurs between a resistance change in the magnetosensitive elements R1 and R2 which are positioned on one side as viewed from the external magnetic body 30 and a resistance change in the magnetosensitive elements R3 and R4 which are positioned on the other side as viewed from the external magnetic body 30. As a result, the magnetosensitive elements R1 to R4 constitute a differential bridge circuit, and a change in the electrical resistance of the magnetosensitive elements R1 to R4 according to a magnetic flux density appears in the terminal electrodes T12 and T13 as a differential signal Va.

The differential signal Va output from the terminal electrodes T12 and T13 is input to a differential amplifier 91 provided on the substrate 10 or externally provided through the connector 80. An output signal from the differential amplifier 91 is fed back to the connecting terminal 71. As illustrated in FIG. 7, the compensation coil 60 is connected between the connecting terminals 71 and 72, whereby the compensation coil 60 generates a cancelling magnetic field in accordance with the output signal from the differential amplifier 91. Further, another compensation coil constituted by a patterned coil may be provided on the element formation surface 21 of the sensor chip 20.

Thus, when the differential signal Va output in accordance with a change in the electric resistance of the magnetosensitive elements R1 to R4 according to the magnetic flux density of a magnetic field to be detected appears in the terminal electrodes T12 and T13, a corresponding current flows in the compensation coil 60 to generate a cancelling magnetic field in the reverse direction. This cancels the magnetic field to be detected. Then, a current output from the differential amplifier 91 is current-voltage converted using a detection circuit 92, whereby the strength of the magnetic field to be detected can be detected. By such closed-loop control, it is possible to detect a magnetic field collected through the external magnetic bodies 30, 41, and 42 with high accuracy.

FIG. 8 is a schematic perspective view for explaining the structure of the external magnetic body 30.

As illustrated in FIG. 8, the external magnetic body 30 has first and second areas 31 and 32 that differ in position in the Z-direction. The first and second areas 31 and 32 are not separated but are integrated. In the first area 31, an end face 31a constituting the XY plane faces the element formation surface 21 of the sensor chip 20 in the Z-direction. That is, the area denoted by reference number 30a illustrated in FIGS. 4 and 5 corresponds to an area of the element formation surface 21 that is covered with the end face 31a of the external magnetic body 30. The Y-direction dimension (height) of the first area 31 is H1. The second area 32 is positioned on the side opposite to the sensor chip 20 with respect to the first area 31, and the Y-direction dimension (height) thereof is H2. The height H2 of the second area 32 is smaller than the height H1 of the first area 31. Thus, when the external magnetic body 30 is mounted on the surface 11 of the substrate 10, the first area 31 contacts the surface 11 of the substrate 10, whereas the second area 32 is in a floating state from the surface 11 of the substrate 10. The first and second areas 31 and 32 may be the same in X-direction dimension (thickness).

FIG. 9 is a schematic perspective view for explaining the structure of the molded member 50.

As illustrated in FIG. 9, the molded member 50 has a bobbin part 51, a terminal fixing part 52, and a flange part 53. The bobbin part 51 is positioned between the terminal fixing part 52 and the flange part 53 in the Z-direction and is wound with a large part of the compensation coil 60. The bobbin part 51 has a hollow shape, inside of which the second area 32 of the external magnetic body 30 is disposed. This results that the compensation coil 60 is wound around the second area 32 of the external magnetic body 30 through the bobbin part 51. The axial direction of the bobbin part 51 is the Z-direction and, accordingly, the axial direction of the compensation coil 60 wound around the bobbin part 51 is also the Z-direction. The bobbin part 51 has a diameter smaller than those of the terminal fixing part 52 and flange part 53, thus preventing the compensation coil 60 wound around the bobbin part 51 from coming off. Further, as described above, the second area 32 of the external magnetic body 30 covered with the bobbin part 51 is in a floating state from the surface 11 of the substrate 10, so that the molded member 50 and compensation coil 60 do not interfere with the surface 11 of the substrate 10.

The terminal fixing part 52 has a bobbin connecting surface S1 constituting the XY plane and connected with the bobbin part 51, a terminal fixing surface S2 constituting the YZ plane and fixed with the connecting terminals 71 and 72, and a bottom surface S3 constituting the XZ plane and facing the surface 11 of the substrate 10. The terminal fixing part 52 also has a hollow shape, inside of which the first area 31 of the external magnetic body 30 is disposed. The connecting terminals 71 and 72 differ in position in the Z-direction; the connecting terminal 71 is positioned on the sensor chip 20 side and the connecting terminal 72 is on the compensation coil 60 side. The terminal parts 71b and 72b of the connecting terminals 71 and 72 coincide in position in the Y-direction, whereas the terminal parts 71a and 72a of the connecting terminals 71 and 72 differ in position in the Y-direction.

As illustrated in FIG. 1, the terminal part 71a of the connecting terminal 71 is connected with one end of the compensation coil 60, and the terminal part 72a of the connecting terminal 72 is connected with the other end of the compensation coil 60. The terminal parts 71b and 72b of the connecting terminals 71 and 72 are connected respectively to via conductors 14 and 15. The via conductor 14 is connected to a terminal 81 of the connector 80, and the via conductor 15 is connected to a terminal 82 of the connector 80. The wiring 12 connected to the terminal electrode group 27 of the sensor chip 20 is connected to a terminal 83 of the connector 80 through the via conductor 13.

The compensation coil 60 has, at its one end, a first section 61 extending in the X-direction along the bobbin connecting surface S1 and a second section 62 extending in the Z-direction along the terminal fixing surface S2. Similarly, the compensation coil 60 has, at its other end, a third section 63 extending in the X-direction along the bobbin connecting surface S1 and a fourth section 64 extending in the Z-direction along the terminal fixing surface S2. The first section 61 and third section 63 extend in parallel to each other in the X-direction while contacting the bobbin connecting surface S1. The second section 62 and fourth section 64 extend in parallel to each other in the Z-direction while contacting the terminal fixing surface S2.

The first and second sections 61 and 62 and the third and fourth sections 63 and 64 differ in height position in the Y-direction, and thus interference therebetween on the bobbin connecting surface S1 and terminal fixing surface S2 is prevented. Further, the Z-direction length of the second section 62 on the terminal fixing surface S2 is different from and larger than the Z-direction length of the fourth section 64 on the terminal fixing surface S2. A projecting positioning part 54 is provided on the terminal fixing surface S2 at a portion above the terminal part 72a, whereby the second section 62 is positioned in the Y-direction.

As described above, in the present embodiment, one end and the other end of the compensation coil 60 both extend along the bobbin connecting surface S1 and terminal fixing surface S2 of the molded member 50. This prevents the positions of the one end and the other end of the compensation coil 60 from changing from condition to condition and product to product. Further, the one end and the other end of the compensation coil 60 both substantially linearly extend in the X- or Z-direction in either section, and there is no section that obliquely extends, so that a magnetic field generated by a current flowing in the one end and the other end of the compensation coil 60 is unlikely to become noise to the magnetosensitive elements R1 to R4.

In addition, currents in mutually opposite directions flow in the first and third sections 61 and 63 that extend in parallel on the bobbin connecting surface S1, so that magnetic fields generated from the first and third sections 61 and 63 cancel each other. Similarly, currents in mutually opposite directions flow in the second and fourth sections 62 and 64 that extend in parallel on the terminal fixing surface S2, so that magnetic fields generated from the second and fourth sections 62 and 64 cancel each other. Thus, it is possible to minimize the influence that a magnetic field generated from the one end and the other end of the compensation coil 60 has on the magnetosensitive elements R1 to R4.

While the preferred embodiment of the present disclosure has been described, the present disclosure is not limited to the above embodiment, and various modifications may be made within the scope of the present disclosure, and all such modifications are included in the present disclosure.

For example, in the above embodiment, both the connecting terminals 71 and 72 are fixed to the terminal fixing surface S2; however, a configuration may be employed in which the connecting terminal 71 is fixed to the terminal fixing surface S2, while the connecting terminal 72 is fixed to the surface opposite to the terminal fixing surface S2.

Further, in order to position the one end and the other end of the compensation coil 60 more accurately in the Y-direction, a slit capable of accommodating the one end and the other end of the compensation coil 60 may be formed at the corner of the molded member 50 serving as the boundary between the bobbin connecting surface S1 and the terminal fixing surface S2.

### [Reference Signs List]

1 magnetic sensor
10 substrate
11 surface of substrate
12 wiring
13-15 via conductor
20 sensor chip
21 element formation surface
22 back surface of sensor chip
23-26 side surface of sensor chip
27 terminal electrode group
28, 29 insulating layer
30, 41, 42 external magnetic body
30a, 41a, 42a area covered with external magnetic body
31 first area
31a end face
32 second area
50 molded member
51 bobbin part
52 terminal fixing part
53 flange part
54 positioning part
60 compensation coil
61 first section
62 second section
63 third section
64 fourth section
71, 72 connecting terminal
71a, 71b, 72, 72b terminal part
80 connector
81-83 terminal
91 differential amplifier
92 detection circuit
G1-G4 magnetic gap
M1-M3, M11, M12, M21, M22, M31, M32 magnetic layer
R1-R4 magnetosensitive element
S1 bobbin connecting surface
S2 terminal fixing surface
S3 bottom surface
T11-T14 terminal electrode

## Claims

1. A magnetic sensor comprising:
a sensor chip having a magnetosensitive element;
an external magnetic body for collecting a magnetic field to be detected in the magnetosensitive element;
a molded member having a bobbin part that cover the external magnetic body and a terminal fixing part;
a compensation coil wound around the external magnetic body through the bobbin part of the molded member; and
a first connecting terminal fixed to the terminal fixing part of the molded member and connected with one end of the compensation coil,
wherein an axis direction of the bobbin part of the molded member is a first direction,
wherein the terminal fixing part of the molded member has a bobbin connecting surface extending perpendicular to the first direction and connected with the bobbin part and a terminal fixing surface extending in parallel to the first direction and fixed with the first connecting terminal, and
wherein the one end of the compensation coil has a first section extending along the bobbin connecting surface and a second section extending along the terminal fixing

2. The magnetic sensor as claimed in claim 1, further comprising a second connecting terminal fixed to the terminal fixing part of the molded member and connected with other end of the compensation coil,
wherein the second connecting terminal is fixed to the terminal fixing surface of the terminal fixing part, and
wherein the other end of the compensation coil has a third section extending along the bobbin connecting surface and a fourth section extending along the terminal fixing surface.

3. The magnetic sensor as claimed in claim 2, wherein the first and third sections extend in parallel to each other.

4. The magnetic sensor as claimed in claim 2, wherein the second and fourth sections extend in parallel to each other.

5. The magnetic sensor as claimed in claim 4, wherein both the second and fourth sections extend in the first direction.

6. The magnetic sensor as claimed in claim 5,
wherein the terminal fixing surface extends in the first direction and a second direction perpendicular to the first direction,
wherein the terminal fixing part further includes a positioning part on the terminal fixing surface, and
wherein the second section of the compensation coil is positioned in the second direction by the positioning part.

7. The magnetic sensor as claimed in any one of claims 1 to 6,
wherein the external magnetic body includes a first area facing the sensor chip in the first direction and a second area positioned on a side opposite to the sensor chip with respect to the first area,
wherein the second area is smaller in height dimension in a second direction perpendicular to the first direction than the first area, and
wherein the bobbin part of the molded member covers the second area of the external magnetic body.
